## Europäisches Patentamt

## European Patent Office

## Office européen des brevets

(19)

(11) **EP 1 480 051 A2**

(12) **EUROPÄISCHE PATENTANMELDUNG**

(43) Veröffentlichungstag:
24.11.2004 Patentblatt 2004/48

(51) Int Cl.7: **G01R 31/36**

(21) Anmeldenummer: **04011915.8**

(22) Anmeldetag: **19.05.2004**

(84) Benannte Vertragsstaaten:
**AT BE BG CH CY CZ DE DK EE ES FI FR GB GR HU IE IT LI LU MC NL PL PT RO SE SI SK TR**
Benannte Erstreckungsstaaten:
**AL HR LT LV MK**

(30) Priorität: **19.05.2003 DE 10322511**
**12.08.2003 DE 10337064**

(71) Anmelder: **Akkumulatorenfabrik Moll GmbH & Co. KG**
**96231 Staffelstein (DE)**

(72) Erfinder:
• **De Doncker, W. Rik, Prof. Dr. ir.**
**B-3000 Leuven (BE)**

• **Buller, Stephan, Dipl.-Ing.**
**52076 Aachen (DE)**
• **Schröder, Stefan, Dipl. Ing.**
**52070 Aachen (DE)**
• **Bohlen, Oliver Sven, Dipl.-Ing. (FH)**
**52062 Aachen (DE)**
• **Gelbke, Manfred, Dr**
**96231 Bad Staffelstein (DE)**
• **Naumann, Rolf**
**96247 Michelau (DE)**

(74) Vertreter: **Zinnecker, Armin, Dipl.-Ing. et al**
**Lorenz-Seidler-Gossel,**
**Widenmayerstrasse 23**
**80538 München (DE)**

(54) **Verfahren und Vorrichtung zur Bestimmung der Hochstrombelastbarkeit einer Batterie**

(57) Ein Verfahren dient zur Bestimmung und/oder Vorhersage der Hochstrombelastbarkeit einer Batterie. Ein vorteilhaftes Verfahren dieser Art ist dadurch gekennzeichnet, dass die Parameter eines Modells der Batterieimpedanz bestimmt werden und dass daraus die Hochstrombelastbarkeit der Batterie bestimmt wird (Fig. 2).

Fig. 2

EP 1 480 051 A2

**Beschreibung**

Die Erfindung betrifft ein Verfahren zur Bestimmung und/oder Vorhersage der Hochstrombelastbarkeit einer Batterie, insbesondere einer Starterbatterie für ein Kraftfahrzeug, und eine Vorrichtung zur Durchführung eines derartigen Verfahrens.

Die Vorhersage des Verhaltens eines elektrischen Energiespeichers, insbesondere einer Batterie, in unterschiedlichen Betriebsarten ist von großer Bedeutung für das Energiemanagement eines Fahrzeugs, insbesondere auch für sicherheitsrelevante Funktionen. Der kritischste Betriebsmodus ist die Belastung des Energiespeichers bzw. der Batterie mit einem hohen Entladestrom. Ein Beispiel von besonderer Bedeutung ist der Startvorgang eines Verbrennungsmotors, bei dem die notwendige Mindestdrehzahl durch einen elektrischen Anlasser erzeugt wird, der von einem elektrischen Energiespeicher, in der Regel einem Blei-Säure-Akkumulator, gespeist wird. Andere Anwendungsfälle sind insbesondere das elektrohydraulische Bremsen, elektrische Lenken und elektrisch unterstützte Anfahren oder Beschleunigen, wie es in Zukunft zunehmend zum Einsatz kommen wird, insbesondere in Hybridfahrzeugen. Diesen Betriebsarten ist gemeinsam, daß sie zum einen mit einem hohen Entladestrom verbunden sind und zum anderen nur relativ kurz, im allgemeinen nur einige Sekunden, andauern.

Wenn die Spannung während dieses Vorgangs eine Mindestspannung unterschreitet, ist es nicht möglich, eine ausreichende Leistung aus dem Energiespeicher bzw. der Batterie zu entnehmen, um den Vorgang erfolgreich zu beenden.

Um die Leistungsfähigkeit einer Starterbatterie eines Kraftfahrzeugs zu bestimmen oder vorherzusagen sind unterschiedliche Ansätze bekannt.

In einigen Fällen wird hierzu der Startverlauf selbst ausgewertet, um auf den Batteriezustand zu schließen. Nach der DE 199 50 424 A1 wird aus Wertepaaren von Spannung und Strom eine Batterieimpedanz bestimmt und deren Verlauf während eines Startvorgangs ausgewertet. Die Veränderung dieser Impedanz als Funktion der Ladungsmenge wird als Kriterium für die Güte des Akkumulators herangezogen. Bei der DE 199 50 424 A1 wird aus einem vergangenen Hochstrom-Entladevorgang auf einen zukünftigen, ähnlichen Vorgang geschlossen. Dies bedeutet, daß periodisch ein zumindest ähnlicher Vorgang mit hoher Strombelastung stattfinden muß. Ist dies nicht der Fall, erfolgt keine ausreichend genaue Bestimmung der Parameter.

Andere Verfahren bestimmen ebenfalls den Widerstand bzw. Impedanzwerte durch Division zusammengehöriger Spannungs- und Stromänderungen. Nach der DE 25 00 058 geschieht diese Widerstandsbestimmung während einer Anregung durch ein Stromsignal. Aus der US 63 31 762 ist ein ähnliches Verfahren bekannt, wobei vorhandene Stromschwankungen im Bordnetz eines Fahrzeugs ausgenutzt werden können.

Basierend auf der vereinfachten Annahme, ein elektrochemischer Akkumulator lasse sich durch eine Spannungsquelle mit Innenwiderstand darstellen, wird aus dem Innenwiderstand auf die Leistungsfähigkeit geschlossen. Nach der DE 25 00 058 wird hauptsächlich der rein ohmsche Anteil zur Bewertung des Batteriezustandes und zur Abschätzung der Startfähigkeit herangezogen. Die Aussage bezieht sich damit auf den Spannungseinbruch bei Belastung, nicht jedoch auf die Dauer des Startvorgangs. Das Batterieverhalten ist dabei deutlich komplexer und kann nicht nur von diesem Parameter dargestellt werden. Die vorbekannten Verfahren erlauben darüber hinaus nur eine einfache Ja/Nein-Entscheidung und keine qualitative Aussage über die Startfähigkeit.

Aufgabe der Erfindung ist es, ein vorteilhaftes Verfahren und eine vorteilhafte Vorrichtung zur Bestimmung und/oder Vorhersage der Hochstrombelastbarkeit einer Batterie vorzuschlagen.

Erfindungsgemäß wird diese Aufgabe bei einem Verfahren der eingangs angegebenen Art durch die Merkmale des Anspruchs 1 gelöst. Die Lösung bei einer Vorrichtung der eingangs angegebenen Art erfolgt durch die Merkmale des Anspruchs 16.

Bei dem Verfahren zur Bestimmung und/oder Vorhersage der Hochstrombelastbarkeit einer Batterie werden die Parameter eines Modells der Batterieimpedanz bestimmt. Daraus wird die Hochstrombelastbarkeit der Batterie bestimmt. In entsprechender Weise ist eine erfindungsgemäße Vorrichtung zur Bestimmung und/oder Vorhersage der Hochstrombelastbarkeit einer Batterie durch einen Controller, vorzugsweise einen Mikrocontroller, zum Bestimmen der Parameter eines Modells der Batterieimpedanz und zum Bestimmen der Hochstrombelastbarkeit der Batterie gekennzeichnet. Vorteilhafte Weiterbildungen der Erfindung sind in den Unteransprüchen beschrieben.

Durch die Erfindung wird eine zuverlässige Vorhersage des Klemmenverhaltens des Energiespeichers bzw. der Batterie während einer Hochstrombelastung ermöglicht.

Vorteilhaft ist es, die Parameter des Modells der Batterieimpedanz aus den gleichzeitigen Messungen der beiden Meßgrößen Batteriespannung und Batteriestrom zu bestimmen.

Vorteilhaft ist, wenn die Messungen in einem begrenzten Frequenzband durchgeführt und/oder ausgewertet werden. Es ist allerdings auch möglich, die Messungen in mehreren Frequenzbändern durchzuführen bzw. auszuwerten. Vorteilhaft ist es, wenn analoge und/oder digitale Filter das Frequenzband der Meßwerte begrenzen, so daß nur ein gewünschtes Frequenzband ausgewertet wird. Die Anpassung der Filtergrenzen kann automatisiert werden, insbesondere unter Auswertung des Leistungsintegrals im gewählten Frequenzband.

Eine weitere vorteilhafte Weiterbildung ist dadurch gekennzeichnet, daß die Parameter des Modells der Batterieimpedanz durch ein Auswerteverfahren bestimmt werden. Vorzugsweise handelt es sich um ein integrierendes Auswerteverfahren.

Die Bestimmung der Parameter des Modells der Batterieimpedanz gelingt durch die Auswertung der Wechselanteile der Meßgrößen.

Eine weitere vorteilhafte Weiterbildung ist dadurch gekennzeichnet, daß der Realteil der Batterieimpedanz aus den mittelwertfreien Wechselanteilen des Batteriestroms und der Batteriespannung in einem Frequenzintervall um eine mittlere Frequenz bestimmt wird. Dies erfolgt vorzugsweise nach folgender Formel:

$$\mathrm{Re}\{Z(f_m)\} \cong \frac{\sum_{k=1}^{N}(u_k \cdot i_k)}{\sum_{k=1}^{N}(i_k \cdot i_k)}$$

Hierin bezeichnen $i_k$ und $u_k$ die zeitdiskret abgetasteten Werte des Batteriestroms i(t) und der Batteriespannung u(t), die über ein Intervall einer Anzahl (N) von Zeitschritten summiert werden.

Nach einer weiteren vorteilhaften Weiterbildung werden die Parameter des Modells der Batterieimpedanz aus einem funktionellen Zusammenhang von Meßgrößen bestimmt, die bei einer oder mehreren Frequenzen bestimmt werden.

Eine weitere vorteilhafte Weiterbildung ist dadurch gekennzeichnet, daß eine oder mehrere Meßgrößen an einem Betriebspunkt gemessen werden und daß die Bestimmung und/oder Vorhersage der Hochstrombelastbarkeit für einen anderen Betriebspunkt erfolgt.

Die Parameter des Modells der Batterieimpedanz können kontinuierlich bestimmt werden. Die vorzugsweise online ermittelten Meßgrößen können zur kontinuierlichen Parametrierung des Modells der Batterieimpedanz genutzt werden.

Das Modell der Batterieimpedanz kann ein modular aufgebautes Ersatzschaltbild sein. Vorzugsweise umfaßt das Ersatzschaltbild konzentrierte Elemente oder besteht das Ersatzschaltbild aus konzentrierten Elementen. In bestimmten Anwendungsfällen kann es vorteilhaft sein, wenn das Ersatzschaltbild aus einer geringen oder minimalen oder geringstmöglichen Anzahl von konzentrierten Elementen besteht. Das Ersatzschaltbild kann für die einzelnen Zeitbereiche der Vorhersage vollständig oder partiell angewendet oder verwendet werden.

Das Modell der Batterieimpedanz und/oder dessen Parametrierung können Bestandteil eines Vorhersagealgorithmus, insbesondere eines adaptiven Vorhersagealgorithmus, sein.

Als Meßgrößen können im Bordnetz vorhandene Signale verwendet werden. In diesem Fall arbeitet das Verfahren passiv. Stattdessen oder zusätzlich ist es allerdings auch möglich, daß Meßgrößen durch Aufprägen von einem oder mehreren Signalen, vorzugsweise Stromsignalen und/oder Spannungssignalen, erzeugt werden. Das Verfahren arbeitet in diesem Fall also aktiv. Anstelle einer oder beider der genannten Möglichkeiten oder zusätzlich zu einer oder beider dieser Möglichkeiten können die Meßgrößen durch das Schalten von Lasten erzeugt werden, vorzugsweise durch das Schalten von im Fahrzeug vorhandenen Lasten.

Die erfindungsgemäße Vorrichtung umfaßt vorzugsweise einen Bandpassfilter für die Wechselanteile der Batteriespannung und/oder einen Bandpassfilter für die Wechselanteile des Batteriestroms oder für eine die Wechselanteile des Batteriestroms repräsentierende Spannung.

Der Controller bzw. Mikrocontroller kann der bereits im Fahrzeug vorhandene Controller bzw. Mikrocontroller sein.

Ein Ausführungsbeispiel der Erfindung wird nachstehend anhand der beigefügten Zeichnung im einzelnen erläutert. In der Zeichnung zeigt

Fig. 1 ein modular aufgebautes Ersatzschaltbild der Batterieimpedanz mit konzentrierten Elementen und

Fig. 2 ein Schaltbild für eine Kraftfahrzeug-Batterie.

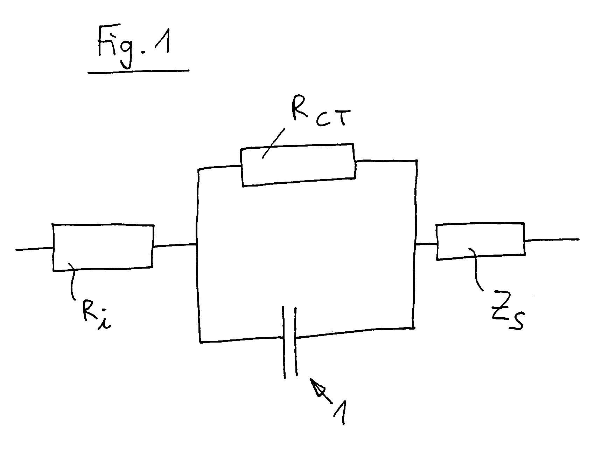

Fig. 1 zeigt ein Ersatzschaltbild eines Energiespeichers 1, insbesondere einer Batterie für ein Kraftfahrzeug, mit konzentrierten Elementen, nämlich einem Innenwiderstand $R_i$, der mit einem RC-Glied und einer Impedanz $Z_S$ in Reihe geschaltet ist, wobei das RC-Glied aus einer Parallelschaltung eines Widerstands $R_{CT}$ und eines Kondensators $C_{DL}$ besteht.

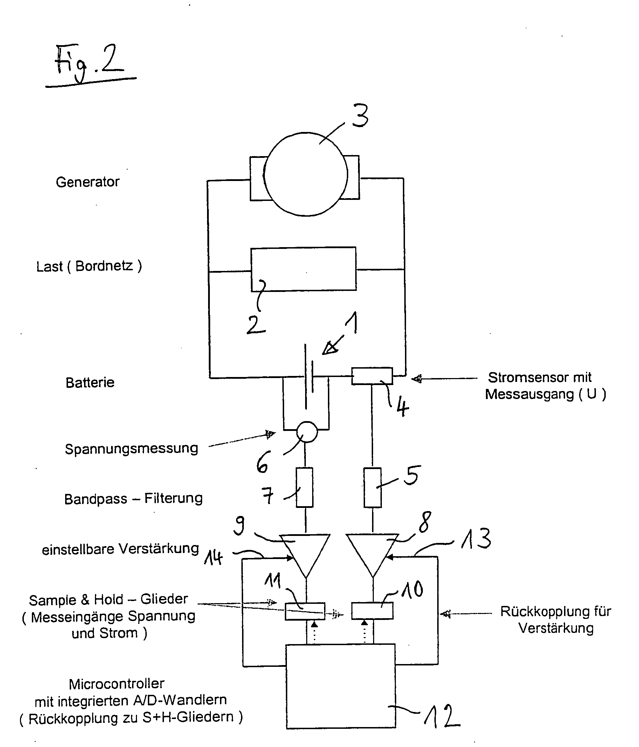

Das Schaltbild gemäß Fig. 2 zeigt eine Batterie 1 für ein Kraftfahrzeug, die eine Last, nämlich ein Bordnetz 2, speist. Mit dem Bordnetz 2 ist ein Generator 3 parallel geschaltet. Im Stromkreis der Batterie ist ein Stromsensor 4 mit einem Meßausgang in Reihe geschaltet. Der Meßausgang des Stromsensors 4 liefert ein Spannungssignal an den Bandpass-Filter 5. Parallel zur Batterie 1 ist eine Spannungsmessung 6 geschaltet, die ein Spannungssignal an den Bandpass-Filter 7 abgibt.

Die Ausgangssignale der Bandpass-Filter 5, 7 werden jeweils einem einstellbaren Verstärker 8, 9 zugeführt, von denen Sie verstärkt und jeweils einem Sample-und-Hold-Glied 10, 11 zugeführt werden. Der Ausgang der Sample-und-Hold-Glieder 10, 11 ist mit einem Mikrocontroller 12 verbunden. In den Mikrocontroller 12 sind A/D-Wandler integriert. Ferner gibt der Mikrocontroller 12 jeweils ein Rückkopplungssignal 13, 14 an die einstellbaren Verstärker 8, 9 ab. Der Mikrocontroller 12 is ferner zu den Sample-und-Holder-Gliedern 10, 11 rückgekoppelt.

Zur Bestimmung der Parameter des Modells der Batterieimpedanz werden die Meßgrößen Batteriestrom und Batteriespannung gemessen. Für die Impedanzbestimmung wird nur der Wechselanteil diese Größen in unterschiedlichen Frequenzbereichen ausgewertet. Um eine gute Auflösung zu erzielen, werden Batteriestrom und Batteriespannung jeweils in Gleichanteil und Wechselanteil getrennt. Dies geschieht durch je einen Hochpass. Um eine Unterabtastung zu vermeiden, wird das Eingangssignal zudem durch je einen Anti-Aliasing-Filter mit einer Grenzfrequenz von 2 kHz begrenzt. Da die Signalamplitude über einen weiten Bereich variieren kann, werden die Signale zudem durch je zwei einstellbare Verstärkerstufen (PGA, Programmable Gain Amplifier) verstärkt. Die Verstärkung wird von dem Mikrocontroller 12 so eingestellt, daß die Signale den Eingangsspannungsbereich der Analog-Digital-Wandler, in denen die Signale für die weitere Verwertung in dem Mikrocontroller gewandelt werden, optimal ausnutzen. Da die Stromwerte und Spannungswerte nach Möglichkeit zeitgleich erfaßt werden sollen, sind zum einen die Signalpfade vom Batteriespannungs- und Batteriestrom identisch aufgebaut, damit sich Phasenverschiebungen und Signallaufzeiten gegenseitig kompensieren, zum anderen werden beide Signale zeitgleich in jeweils einem Halteglied 10, 11 gespeichert. Diese werden von dem Mikrocontroller 12 gesteuert, der die Werte dann sequentiell aus den Haltegliedern 10, 11 liest und in die ebenfalls in dem Controller befindlichen Analog-Digital-Wandler einliest. Weitere Signalpfade zur Aufbereitung der Gleichanteile von Spannung und Strom stellen diese Werte ebenfalls dem Mikrocontroller zur weiteren Auswertung zur Verfügung. Darüber hinaus wird über einen weiteren Sensor die Batterietemperatur bestimmt und an den Mikrocontroller übermittelt.

In dem Mikrocontroller werden aus den Meßwerten bzw. Meßdaten die Parameter des Modells der Batterieimpedanz (Impedanzparameter) berechnet. Aus diesen werden die Parameter des Modells des Energiespeichers bestimmt. Mit Hilfe des Modells bzw. der Parameter des Modells wird ein Wert für die Startfähigkeit bzw.

Hochstrombelastbarkeit der Batterie ermittelt bzw. bestimmt. Durch Auswertung weiterer Größen, insbesondere der Gleichanteile von Batteriespannung und Batteriestrom sowie der Batterietemperatur, können zusätzliche Zustandsgrößen wie insbesondere der Ladezustand der Batterie bestimmt werden. Die Zustandsgrößen, direkten Messgrößen sowie die bei den Berechnungen ermittelten Hilfsgrößen können an externe oder im Fahrzeug integrierte Auswerte- und/oder Anzeigegeräte übermittelt werden, insbesondere über eine serielle Schnittstelle und über ein CAN-Bus-Modul.

Durch die Erfindung wird es ermöglicht, das Klemmenverhalten eines elektrochemischen Energiespeichers während einer Entladung mit hohem Strom vorherzusagen. Hierzu wird ein Modell des Energiespeichers, das vorzugsweise konzentrierte Elemente umfasst, durch Bestimmung von impedanzbasierten Parametern parametriert.

Das Modell des Energiespeichers kann als elektrisches Ersatzschaltbild (ESB; siehe beispielsweise Fig. 1) dargestellt werden. Die einzelnen Elemente des elektrischen Ersatzschaltbildes stellen einen eindeutigen Zusammenhang zwischen dem durch das Element fließenden Strom und der über dem Elemente anliegenden Spannung dar. Die Elemente werden durch einen oder mehrerer Parameter charakterisiert. Das Modell ist derart gestaltet, daß mit möglichst wenig Parametern das Klemmenverhalten des Energiespeichers für den jeweiligen Anwendungsfall ausreichend genau vorhergesagt werden kann.

Die Parameter des Modells werden während des Betriebs bestimmt, so daß das Modell den aktuellen Zustand des Energiespeichers beschreibt und eine Vorhersage des Klemmenverhaltens bei diesem Zustand erlaubt. Um Vorhersagen für einen anderen als den momentanen Betriebszustand zu ermöglichen, werden Zuordnungen der Parameter zu anderen Zustandsgrößen wie Temperatur oder Ladezustand verwendet. Diese Zuordnungen können in Form von Tabellen, von mathematischen Funktionen oder von Kombinationen unterschiedlicher Verfahren dargestellt sein (Alternativen: Expertensysteme, Regelwerke, Kombination mit Fuzzy-Logik, neuronale Netzwerke und Ähnliches). Die Zuordnungen können einer Größe direkt einen andere Größe gegenüberstellen oder differentiell arbeiten, d.h. der Veränderung einer Größe die Veränderung einer anderen Größe gegenüberstellen.

Zusätzlich zu den im Betrieb bestimmten Parametern können vor Inbetriebnahme Vorgabewerte für die Parameter bestimmt und in Tabellen abgelegt werden oder Parameter in Betriebspausen bestimmt werden.

Die Parameter des Ersatzschaltbildes leiten sich aus Impedanzwerten ab, die, basierend auf Leistungsbetrachtungen, bestimmt werden und die Größen, Spannung und Strom auswerten. Eine Bestimmung des ohmschen Innenwiderstands nach diesem Prinzip ist in der prioritätsälteren, nicht vorveröffentlichten deutschen Patentanmeldung 102 05 120.8-34, auf die hiermit Bezug genommen wird, beschrieben. Durch Erweiterung des Verfahrens lassen sich die Realteile der komplexen Impedanz des Energiespeichers bei unterschiedlichen Frequenzen oder in unterschiedlichen Frequenzintervallen bestimmen. Hierzu muß das Signalspektrum eingegrenzt werden. Dies kann durch analoge oder digitale Filter oder eine geeignete Kombination von beiden geschehen. Aus den so bestimmten Impedanzwerten ergeben sich die Parameter des Modells durch mathematische Zuordnungen oder Tabellen mit einem oder mehreren Impedanzwerten sowie konstanten oder veränderlichen Hilfsgrößen.

Durch die Erfindung wird es ermöglicht, ein Verfahren zur Vorhersage der Hochstrombelastbarkeit von Batterien, insbesondere von Blei-Säure-Batterien, auf der Basis eines Modells der Batterieimpedanz durchzuführen. Es ist möglich, das Modell der Batterieimpedanz durch Impedanzmessungen unter Verwendung eines über die Wirkwiderstandsermittlung arbeitenden, integrierenden Auswerteverfahrens zu parametrieren. Dabei ist es möglich, Meßgrößen bzw. Signale verschiedener Frequenzbereiche auszuwerten. Es ist ferner möglich, daß die funktionalen Zusammenhänge zwischen Impedanzwerten und Modellparametern oder die Kenngrößen dieser Zusammenhänge durch das Auswerten der Spannungs- und Stromverläufe während eines Startvorgangs adaptiert werden. Bei dem Verfahren kann eine automatische Verstärkungswahl vor den Meßeingängen durchgeführt werden, um eine optimale Anpassung des Signal-Rausch-Abstandes zu erreichen. Die Meßwerterfassung kann mit einer hohen Meßrate geschehen, insbesondere derart, daß der zeitliche Abstand zweier Messungen mindestens um den Faktor 2 kleiner ist als die kleinste Zeitkonstante des zugrundeliegenden Modells des Energiespeichers. Die Meßrate kann 10 kHz betragen. Die Verarbeitung der Meßdaten geschieht vorzugsweise in einem Mikrorechner. Die Meßwerte oder vorverarbeiteten Zwischenwerte können in einem flüchtigen oder nicht flüchtigen Speicher vor der Weiterverarbeitung abgelegt werden. Die Zustandsvariablen des zu parametrierenden Modells können in einem nicht flüchtigen Speicher abgelegt werden.

Es ist möglich, bei dem erfindungsgemäßen Verfahren eine Leistungsbetrachtung durchzuführen, die integrierend und damit stabiler als differenzierende Verfahren ist. Das Modell kann eine komplexere Impedanz und damit den zeitlichen Verlauf des Startvorgangs berücksichtigen. Das Verfahren kann in der Weise durchgeführt werden, daß eine Minimalspannung aufgrund der Impedanz und eines prognostizierten Stromprofils vorhergesagt werden kann. Die Parameter des Modells können aus beliebigen Lade- oder Entladevorgängen ermittelt werden.

**Patentansprüche**

1. Verfahren zur Bestimmung und/oder Vorhersage der Hochstrombelastbarkeit einer Batterie, **dadurch gekennzeichnet, dass** die Parameter eines Modells der Batterieimpedanz bestimmt werden und dass daraus die Hochstrombelastbarkeit der Batterie bestimmt wird.

2. Verfahren nach Anspruch 1, **dadurch gekennzeichnet, dass** die Parameter des Modells der Batterieimpedanz aus den gleichzeitigen Messungen der beiden Meßgrößen Batteriespannung (u(t)) und Batteriestrom (i(t)) bestimmt werden.

3. Verfahren nach Anspruch 2, **dadurch gekennzeichnet, dass** die Messungen in einem begrenzten Frequenzband durchgeführt und/oder ausgewertet werden.

4. Verfahren nach einem der vorhergehenden Ansprüche, **dadurch gekennzeichnet, dass** die Parameter des Modells der Batterieimpedanz durch ein Auswerteverfahren bestimmt werden.

5. Verfahren nach Anspruch 4, **dadurch gekennzeichnet, dass** das Auswerteverfahren ein integrierendes Auswerteverfahren ist.

6. Verfahren nach einem der vorhergehenden Ansprüche, **dadurch gekennzeichnet, dass** die Bestimmung der Parameter des Modells der Batterieimpedanz durch die Auswertung der Wechselanteile der Meßgrößen durchgeführt wird.

7. Verfahren nach einem der vorhergehenden Ansprüche, **dadurch gekennzeichnet, dass** der Realteil der Batterieimpedanz ($Re(Z(f_m))$) aus den mittelwertfreien Wechselanteilen des Batteriestroms (i(t)) und der Batteriespannung (u(t)) in einem Frequenzintervall um eine mittlere Frequenz ($f_m$) nach der Formel

$$\mathrm{Re}\{Z(f_m)\} \cong \frac{\sum\limits_{k=1}^{N}\left(u_k \cdot i_k\right)}{\sum\limits_{k=1}^{N}\left(i_k \cdot i_k\right)}$$

bestimmt wird, wobei $i_k$ und $u_k$ die zeitdiskret abgetasteten Werte des Batteriestroms (i(t)) und der Batteriespannung (u(t)) bezeichnen, die über ein Intervall einer Anzahl (N) von Zeitschritten summiert werden.

8. Verfahren nach einem der vorhergehenden Ansprüche, **dadurch gekennzeichnet, dass** die Parameter des Modells der Batterieimpedanz aus einem funktionellen Zusammenhang von Meßgrößen bestimmt werden, die bei einer oder mehreren Frequenzen bestimmt werden.

9. Verfahren nach einem der vorhergehenden Ansprüche, **dadurch gekennzeichnet, dass** eine oder mehrere Messgrößen an einem Betriebspunkt gemessen werden und dass die Bestimmung und/oder Vorhersage der Hochstrombelastbarkeit für einen anderen Betriebspunkt erfolgt.

10. Verfahren nach einem der vorhergehenden Ansprüche, **dadurch gekennzeichnet, dass** die Parameter des Modells der Batterieimpedanz kontinuierlich bestimmt werden.

**11.** Verfahren nach einem der vorhergehenden Ansprüche, **dadurch gekennzeichnet, dass** das Modell der Batterieimpedanz ein modular aufgebautes Ersatzschaltbild mit vorzugsweise konzentrierten Elementen ist.

**12.** Verfahren nach einem der vorhergehenden Ansprüche, **dadurch gekennzeichnet, dass** das Modell der Batterieimpedanz Bestandteil eines vorzugsweise adaptiven Vorhersagealgorithmus ist.

**13.** Verfahren nach einem der vorhergehenden Ansprüche, **dadurch gekennzeichnet, dass** als Meßgrößen im Bordnetz vorhandene Signale verwendet werden.

**14.** Verfahren nach einem der vorhergehenden Ansprüche, **dadurch gekennzeichnet, dass** Meßgrößen durch Aufprägen von Signalen, vorzugsweise Stromsignalen und/oder Spannungssignalen, erzeugt werden.

**15.** Verfahren nach einem der vorhergehenden Ansprüche, **dadurch gekennzeichnet, dass** Meßgrößen durch das Schalten von Lasten erzeugt werden.

**16.** Vorrichtung zur Bestimmung und/oder Vorhersage der Hochstrombelastbarkeit einer Batterie, insbesondere zur Durchführung des Verfahrens nach einem oder mehreren der Ansprüche 1 bis 15, **gekennzeichnet durch**, einen Controller zum Bestimmen der Parameter eines Modells der Batterieimpedanz und zum Bestimmen der Hochstrombelastbarkeit der Batterie.

**17.** Vorrichtung nach Anspruch 16, **gekennzeichnet durch** einen Bandpassfilter für die Wechselanteile der Batteriespannung.

**18.** Vorrichtung nach Anspruch 16 oder 17, **gekennzeichnet durch** einen Bandpassfilter für die Wechselanteile des Batteriestroms oder für eine die Wechselanteile des Batteriestroms repräsentierende Spannung.

**19.** Vorrichtung nach einem der Ansprüche 16 bis 18, **dadurch gekennzeichnet, dass** der Controller der bereits im Fahrzeug vorhandene Controller ist.

Fig. 1

Fig. 2

Generator

Last ( Bordnetz )

Batterie

Stromsensor mit
Messausgang ( U )

Spannungsmessung

Bandpass – Filterung

einstellbare Verstärkung

Sample & Hold – Glieder
( Messeingänge Spannung
und Strom )

Rückkopplung für
Verstärkung

Microcontroller
mit integrierten A/D-Wandlern
( Rückkopplung zu S+H-Gliedern )

8